Europäisches Patentamt

European Patent Office

Office européen des brevets

(19)

(11) Publication number: **0 071 648**
**A1**

# EUROPEAN PATENT APPLICATION

published in accordance with Art. 158(3) EPC

(12)

(21) Application number: **82900384.7**

(22) Date of filing: **04.02.82**

Data of the international appli-
cation taken as a basis:

(86) International application number:
**PCT/JP 82/00033**

(87) International publication number:
**WO 82/02799 (19.08.82 82/20)**

(51) Int. Cl.³: **H 01 L 29/80**, H 01 L 29/90

---

(30) Priority: **05.02.81 JP 16063/81**

(43) Date of publication of application: **16.02.83**
**Bulletin 83/7**

(84) Designated Contracting States: **FR**

(71) Applicant: **SONY CORPORATION,**
**7-35 Kitashinagawa 6-Chome Shinagawa-ku,**
**Tokyo 141 (JP)**

(72) Inventor: **TAKAKUWA, Hidemi Sony Corporation, 7-35,**
**Kitashinagawa 6-chome Shinagawa-ku, Tokyo 141 (JP)**
Inventor: **AOKI, Tsuneyoshi Sony Corporation, 7-35,**
**Kitashinagawa 6-chome Shinagawa-ku, Tokyo 141 (JP)**
Inventor: **SUZUKI, Kaoru Sony Corporation, 7-35,**
**Kitashinagawa 6-chome Shinagawa-ku, Tokyo 141 (JP)**
Inventor: **ISHITANI, Akiyasu Sony Corporation, 7-35,**
**Kitashinagawa 6-chome Shinagawa-ku, Tokyo 141 (JP)**

(74) Representative: **Cabinet BERT, DE KERAVENANT &**
**HERRBURGER, 115, Boulevard Haussmann,**
**F-75008 Paris (FR)**

---

(54) **SEMICONDUCTOR DEVICE.**

(57) A field effect transistor (35) and a gate protecting diode
(36) are formed on the same substrate. The breakdown
voltage of the diode is set to be lower than that of the gate
by increasing the thickness of diode region (34b) and/or
increasing the concentration of impurities.

0071648

DESCRIPTION

TITLE OF THE INVENTION

Semiconductor Apparatus

TECHNICAL FIELD

The present invention relates to a field-effect transistor having a gate protecting diode.

BACKGROUND ART

It is known that a substrate made of GaAs and the like having high carrier migration is formed thereon with a field-effect transistor (FET) having a Schottky barrier-gate or PN junction gate. In order to protect the gate of the FET from excessively large voltages applied across the gate and the source of this FET, there is provided a protecting device for clamping that voltage. Since it is difficult to form a GaAs diode, which has a yielding voltage lower than the gate thereof, within the same layer, there is practically proposed for the above purpose such one that a protecting diode made of silicon is provided independently from the GaAs substrate and then interconnected therebetween by external lead wires.

DISCLOSURE OF INVENTION

The present invention aims to provide such a semiconductor apparatus in which a gate protecting diode is formed on a substrate same as that of an FET thus simplifying the overall arrangement. In accordance with the present invention, a semiconductor layer formed by ion injection or epitaxial growth is formed thereon with an FET and a diode, whereby a reverse-biasing yielding voltage (withstanding voltage) of the diode is made smaller than that between the gate and the channel of the FET. To this end, the impurity concentration of a region where the junction of the diode is formed is selected higher than that of the channel of the FET and/ or the thickness of the region where the diode is formed is selected more than that of the channel layer of the FET thus resulting in different yielding voltage mechanisms.

BRIEF DESCRIPTION OF DRAWINGS

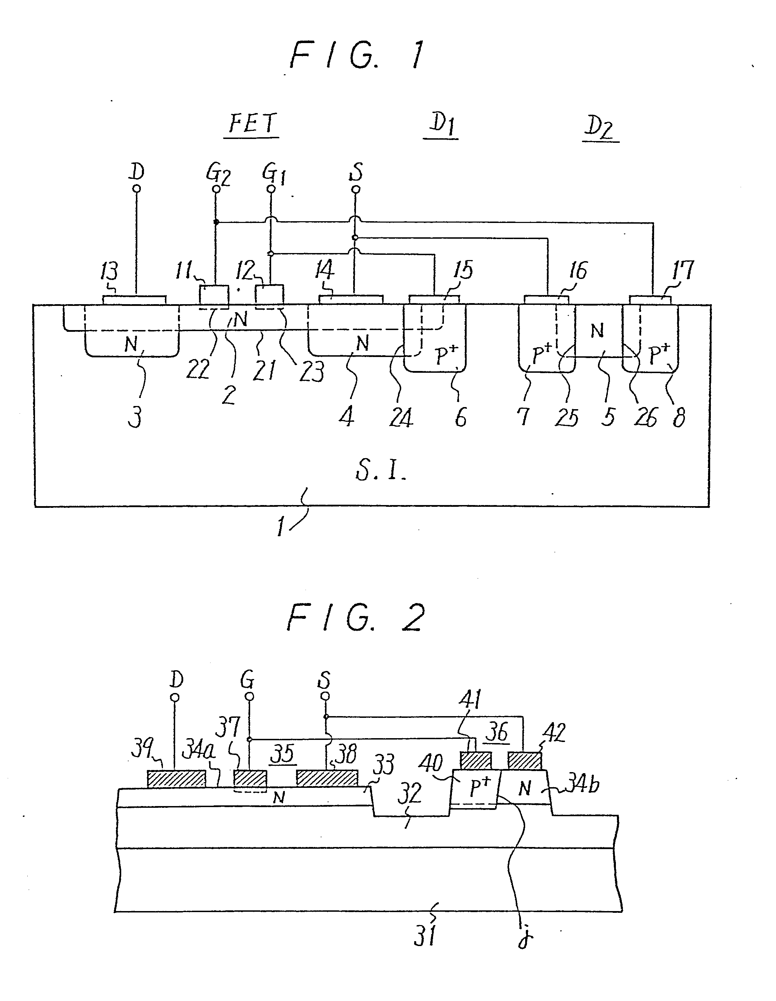

Figs. 1 and 2 are cross-sectional diagrams each showing one example of a semiconductor apparatus according to the present invention.

BEST MODE FOR CARRYING OUT THE INVENTION

Fig. 1 is a cross-sectional diagram showing one embodiment of an apparatus according to the present invention. In this case, a semi-insulating GaAs substrate 1 is prepared, on which a semiconductor layer 2 of an N-type conductivity is formed. This semiconductor layer 2 will make the channel portion of an FET. The region between this semiconductor layer and an N-type layer (not shown), which will make other FET and formed at the same time, is electrically separated from one another by the non-doping portions in the substrate 1. The N-type layer 2 is formed by the injection of, for example, silicon (Si) ion at dose amount of $2 \times 10^{12}$ $cm^{-2}$ with the energy of 70 KeV. At this time, the depth of the layer is 0.2 µm, and the peak value of the impurity concentration is $2 \times 10^{17}$ $cm^{-3}$. The semiconductor regions of N-type conductivity are formed, which make a drain region 3, a source region 4, each being contact with the layer 2, and a region 5 which is apart from the FET and will form a part of a protecting diode. The N-type regions 3, 4 and 5 are each formed by the injection of, for example, silicon (Si) ion at dose amount of $1 \times 10^{13}$ $cm^{-2}$ with the energy of 200 KeV. At that time, the depth of the layer is 0.6 µ and the peak value of the impurity concentration is $5 \times 10^{17}$ $cm^{-3}$. On the other hand, semiconductor regions of $P^{+}$ type conductivity are formed which will make an anode region 6 of a diode contacting with the source region 4 to use the same as the cathode thereof, and respective anode regions 7 and 8 of two series diodes which take the N type region 5 as the cathodes thereof. Each of the $P^{+}$ type regions 6, 7 and 8 is formed by the injection of, for example, zinc (Zn) ion at dose amount of $2 \times 10^{15}$ $cm^{-2}$ with the energy of 100 KeV.

The N-type channel layer 2 between the source region 4 and the drain region 3 is provided thereon with a metal layer for forming the Schottky barrier together with it, on which first and second gates 12 and 11 of the respective FET are formed. These are formed by the evaporation of aluminum (Al) of, for example, 6000Å thick and patterned, each being of 1.5 μm wide. The distances between the source region 4 and the first gate 12; the first gate 12 and the second gate 11; and the second gate 11 and the drain region 3 are respectively 2.5 μm, 3 μm and 4 μm. A source electrode 14 and a drain electrode 13 are respectively formed on the N-type source and drain regions 4 and 3 by ohmic contact. These are formed by the evaporations of, for example, gold-germamium (Au-Ge) alloy of 1600Å thick and nickel (Ni) of 400Å thick, and then patterned by lift-off method. The $P^+$ type regions 6, 7 and 8 are formed thereon with electrodes 15, 16 and 17 by ohmic contact, respectively. These are formed by the evaporation of, for example, titanium (Ti) of 500Å thick and gold (Au) of 4500Å thick. These metals are formed on the source and drain electrodes 14 and 13 so as to reduce the wiring resistance. The remaining surfaces of the substrate are protected by a silicon nitride ($Si_3N_4$) layer.

The $P^+$ type region 6 and the source which also serves as the cathode region 4 form a PN junction 24 of a diode constituting a first protecting element. Seeing from the upper surface thereof, the junction 24 is formed as in a zigzag line to increase its junction area thus increasing the current capacity.  The anode electrode 15 is connected to the first gate 12.  This connection is achieved by extending the metal layer of the anode electrode 15 on the bonding portion of the metal layer of the first gate 12.  The $N^+$ type region 5 and the P type regions 7 and 8 form PN junctions 25 and 26 of P-N-P serial diodes constituting a second protecting element, in which one anode electrode 17 is connected to the second gate 11 and the other anode electrode 16 is connected to the source electrode 14.

In accordance with the present invention, the yielding voltages presented by the junctions 24, 25 and 26 of the protecting elements are selected to be lower than the yielding voltages presented by respective Schottky barriers 23 and 22 in the first and second gates 12 and 11 of the FET.  To this end, the N type regions 4 and 5 of the diodes have the impurity concentrations higher than that of the channel layer 2 and/or thicknesses (depths) thereof are selected to be larger than that of the channel layer.  The yielding voltage of each of the junctions 24, 25 and 26 is about 8.5 V in the example as described above.  This value is substantially coincident with a theoretical value presented by a normal avalanche yield which is caused by the impurity concentration.  In order to keep this yielding voltage low, the thicknesses of the N type regions 4 and 5 are increased to some extent where the influence by the surface depletion layers thereof is reduced. The $P^+$ type regions 6, 7 and 8 are sufficiently higher in their impurity concentrations as compared with the N type regions 4 and 5, their depletion layers in the junctions are extended mainly to the N type regions, and their thicknesses are so large that the junctions are formed on only the side surfaces thereof and the junction capacitances are small.

The yielding voltage of each of the gate barriers 22 and 23 is about 20 V in the aforementioned example (in this case, pinch-off voltage is about 2 V). This is several times as high as a value expected from the avalanche yielding phenomenon and does not show an appreciable yielding characteristic by the existence of a leak current. The reason for this may be considered as follows. The depletion layers extended from the barriers 22 and 23 are first reached to the depletion layer in the boarder 21 between the channel layer 2 and the substrate 1 by the pinch-off voltage (punch-through), and when the voltage becomes higher than the pinch-off voltage, these depletion layers are coupled together and extended horizontally within the channel layer 2, whereby the strength of the electric field applied to the barriers is weakened (of course, the present invention is not limited to the above explanation). In order to achieve the above electric field weakening effect, the thickness of the channel layer 2 is reduced and/or its impurity concentration is reduced. As stated above, the yielding mechanisms in the gate of the FET and the protecting diodes are made different from each other, whereby the yielding voltage of the diodes is made lower than that of the gate.

The apparatus according to the present invention can be constructed by the epitaxial growing method of liquid or vapor. In this case, the thickness of the layer is determined by the etching elimination. Fig. 2 shows an example of this case. In Fig. 2, reference numeral 31 represents a semi-insulating semiconductor substrate, for example, GaAs substrate, which is provided on its one major surface with a buffer layer 32 having a high resistance formed of a liquid-phase epitaxial layer made of, for example, GaAs, on which a semiconductor layer 33 of one conductivity type, for example, N-type is formed. A first portion 34a of this semiconductor layer 33 is provided thereon with an FET, for example, FET 35 of the Schottky barrier type, and other second portion 34b is provided thereon with a diode 36.

The FET 35 is formed in such a manner that the first portion 34a of the semiconductor layer 33 is deposited thereon with a Schottky metal or a gate electrode 37 made of, for example, Aℓ to produce the Schottky barrier on this deposited portion. A source electrode 38 and a drain electrode 39, each being made of, for example, Au-Ge system metal are deposited at both sides of the gate electrode 37 to grip the same therebetween by an ohmic contact method.

Whereas, the diode 36 is formed such that the second portion 34b of the semiconductor layer 33 is, for example, selectively formed with a region 40 of other conductivity type, for example, P type to form a PN junction j, in which each of P and N regions is deposited thereon with an anode electrode 41 and a cathode electrode 42 by an ohmic contact method.

The first portion 34a of the semiconductor layer 33, on which the FET 35 is formed, is made, for example, thinner as compared with the second portion 34b on which the diode 36 is formed. In other words, when the concentration of each of, for example, the first and second portions 34a and 34b is selected to be about $10^{17}$ cm$^{-3}$ and the thickness of the second portion 34b is selected to be 0.4 μm, the thickness of the first portion 34a is selected to be 0.2 μm.

The Schottky gate withstanding voltage of the FET formed on the portion 34a of the semiconductor layer 33 whose thickness is thin as described above is several times as high as the theoretical value of the avalanche breakdown obtained from the impurity concentration of the portion 34a of the semiconductor layer 33 which forms the channel layer of this FET.

If the yielding voltage of the protecting diode according to the present invention is low, it may be formed by the Schottky barrier or can be formed by the combination of the PN junctions.

CLAIM

A semiconductor device comprising a semiconductor substrate, a field-effect transistor in said substrate having a source, a gate and a drain, and a diode in said substrate connected between said gate and said source, characterized in that the thickness and/or the impurity concentration of a region in which a depletion layer mainly extends when said diode is reversely biased is larger than that of a channel region facing with said gate.

Reference numeral 1 represents the semiconductor substrate, 2 the semiconductor layer, 3 the drain region, 4 the source region, 5 the cathode region, 6, 7 and 8 the anode regions, 11 and 12 the first and second gates, 31 the semi-insulating substrate, 32 the buffer layer, 33 the semiconductor layer, 37 the gate electrode, 38 and 39 the source electrode and drain electrode, and 41 and 42 the anode electrode and cathode electrode.

FIG. 1

FET            D₁            D₂

FIG. 2

# INTERNATIONAL SEARCH REPORT

International Application No PCT/JP82/000338

## I. CLASSIFICATION OF SUBJECT MATTER (if several classification symbols apply, indicate all) 3

According to International Patent Classification (IPC) or to both National Classification and IPC

Int. Cl.$^3$   H01L 29.80, 29/90

## II. FIELDS SEARCHED

### Minimum Documentation Searched 4

| Classification System | Classification Symbols |
|---|---|
| I P C | H01L 29/76 – 29.80, 29/90 |

### Documentation Searched other than Minimum Documentation to the Extent that such Documents are Included in the Fields Searched 5

Kokai Jitsuyo Shinan Koho      1971 – 1982

## III. DOCUMENTS CONSIDERED TO BE RELEVANT 14

| Category* | Citation of Document, 16 with indication, where appropriate, of the relevant passages 17 | Relevant to Claim No. 18 |
|---|---|---|
| X | US,A, 3,754,171 (Hitachi Ltd.), 21. August. 1973 (21.8.73) | 1 |
| Y | UP,A, 53–48487 (Fujitsu Limited), 1. May. 1978 (1.5.78), Column 2, lines 5 to 20 | 1 |
| Y | JP,A, 52–146185 (Fujitsu Limited), 5. December. 1977 (5.12.77), Column 3, line 18 to column 4, line 14 | 1 |
| Y | GB, A, 1,339,250 (RCA Co.), 28. November. 1973 (28.11.73) | 1 |
| Y | Solid–State Electronics, Vol 9 (August. 1966), Pergamon Press (London), P831–845 | 1 |

* Special categories of cited documents: 15

"A" document defining the general state of the art
"E" earlier document but published on or after the international filing date
"L" document cited for special reason other than those referred to in the other categories
"O" document referring to an oral disclosure, use, exhibition or other means

"P" document published prior to the international filing date but on or after the priority date claimed
"T" later document published on or after the international filing date or priority date and not in conflict with the application, but cited to understand the principle or theory underlying the invention
"X" document of particular relevance

## IV. CERTIFICATION

| Date of the Actual Completion of the International Search 2 | Date of Mailing of this International Search Report 2 |
|---|---|
| April 30, 1982 (30.04.82) | May 17, 1982 (17.05.82) |

| International Searching Authority 1 | Signature of Authorized Officer 20 |
|---|---|
| Japanese Patent Office | |

Form PCT/ISA/210 (second sheet) (October 1977)